# FASCICULE DE BREVET EUROPEEN

(11) **EP 0 714 169 B1**
(45) Date de publication et mention de la délivrance du brevet: **05.09.2001**
(21) Numéro de dépôt: 95410130.9
(22) Date de dépôt: 23.11.1995
(51) Int. Cl.: H03M 1/06, H04N 5/18

(54) **Circuit d'asservissement d'un signal sur une valeur de référence**
Schaltung zur Klemmung eines Signals auf einen Referenzwert
Circuit for clamping a signal to a reference value

(30) Priorité: 25.11.1994 FR 9414414
(43) Date de publication de la demande: 29.05.1996
(73) Titulaire: STMicroelectronics S.A., 94250 Gentilly (FR)
(72) Inventeur: Chesneau, David, F-38240 Meylan (FR)
(74) Mandataire: de Beaumont, Michel

(56) Documents cités:
- EP-A- 0 220 894
- EP-A- 0 280 123
- PATENT ABSTRACTS OF JAPAN vol. 015 no. 165 (E-1061) ,25 Avril 1991 & JP-A-03 035666 (MITSUBISHI ELECTRIC CORP) 15 Février 1991,
- PATENT ABSTRACTS OF JAPAN vol. 011 no. 046 (E-479) ,12 Février 1987 & JP-A-61 210770 (HITACHI LTD;OTHERS: 01) 18 Septembre 1986,

## Description

La présente invention concerne un circuit pour asservir un signal sur une valeur de référence continue lors d'intervalles de temps successifs afin de rétablir régulièrement un niveau de base du signal. La présente invention concerne plus particulièrement un tel circuit d'asservissement permettant, dans un téléviseur, de rétablir le niveau du noir d'un signal de chrominance ou de luminance après les retours de ligne.

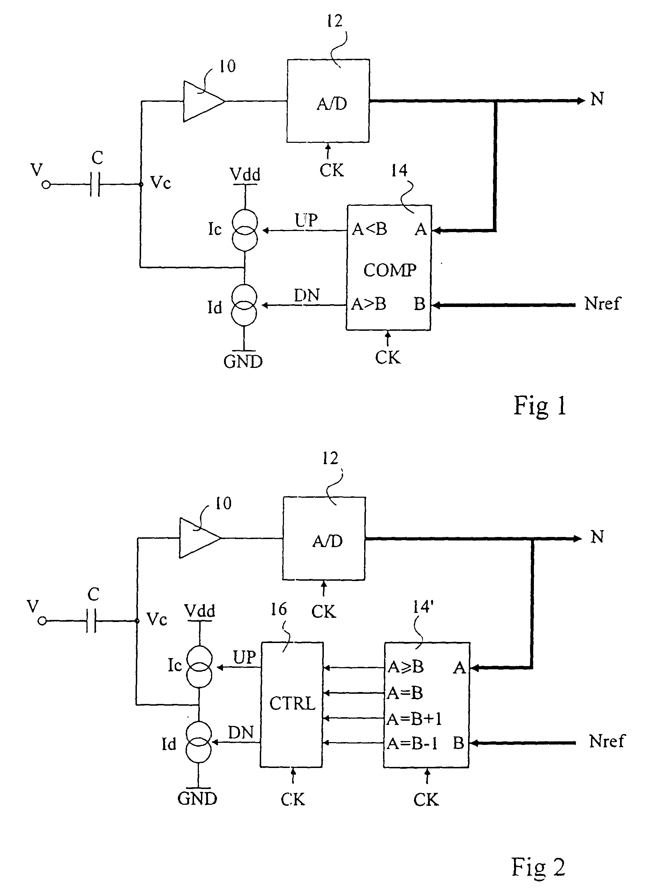

La figure 1 représente un circuit classique d'asservissement d'un signal de luminance ou chrominance sur le niveau du noir. Le signal non asservi V est appliqué sur l'entrée d'un amplificateur 10 par l'intermédiaire d'une capacité C. Le signal Vc à l'entrée de l'amplificateur 10 correspond au signal à asservir sur le niveau du noir. Ce signal Vc, amplifié par l'amplificateur 10, est le plus souvent converti en numérique par un convertisseur analogique/numérique 12. Un comparateur numérique 14 reçoit sur une entrée A la sortie numérique N du convertisseur 12 et sur une entrée B une valeur numérique de référence Nref. La borne de la capacité C, sur laquelle on prélève le signal asservi Vc, est reliée à un potentiel d'alimentation haut Vdd par une source de courant de charge Ic, et à la masse GND par une source de courant de décharge Id. La source de charge Ic est activée par un signal UP délivré par le comparateur 14 lorsque la valeur N est inférieure à Nref. La source Id est activée par un signal DN délivré par le comparateur 14 lorsque la valeur N est supérieure à Nref. La source Ic ou Id est activée au rythme d'une horloge CK fournie au comparateur 14 et au convertisseur 12.

Avec cette configuration, lorsque la valeur N est supérieure à Nref, par exemple, la source Id est activée et décharge progressivement la capacité C. La tension Vc diminue, et le signal N suit l'évolution de la tension Vc. Lorsque le signal N atteint Nref, aucune des sources Ic ou Id n'est activée, et la tension Vc garde la valeur atteinte.

Ce circuit n'est utilisé que pendant les retours de ligne ; pendant la durée des lignes, les sources de courant Ic et Id sont désactivées.

Pendant une phase d'asservissement, la tension V est supposée constante. En pratique, cette tension V comporte du bruit provoqué par divers phénomènes parasites environnants. Ce bruit est directement transmis par la capacité C et l'amplificateur 10 à l'entrée du convertisseur 12 et peut provoquer une modification du signal numérique N. Le bruit, qui est aléatoire et de valeur moyenne nulle, n'est pas gênant en boucle ouverte, c'est-à-dire en dehors des phases d'asservissement.

Toutefois, pendant les phases d'asservissement, le circuit effectue une correction du signal N à chaque cycle d'horloge en fonction de la valeur du signal N trouvée au cycle précédent. Ainsi, par exemple, si une impulsion parasite de la tension Vc provoque une augmentation de la valeur N, le circuit effectue, au cycle d'après, une correction négative de la tension Vc, même si cette tension Vc subit simultanément une impulsion parasite négative : la correction négative et l'impulsion parasite négative sont cumulées et augmentent l'erreur de la valeur N plutôt que de la diminuer. De telles erreurs cumulatives ont une probabilité non-négligeable de se produire et provoquent une oscillation du signal N avec une amplitude de plusieurs unités. Alors qu'une oscillation d'une unité est normale et tolérable, une oscillation de plusieurs unités devient visible à l'écran et détériore la qualité de l'image.

En outre, le convertisseur 12 généralement utilisé dans un tel circuit est un convertisseur qui a un temps de latence de plusieurs cycles d'horloge CK, souvent trois, entre l'instant où est acquis un échantillon du signal d'entrée du convertisseur et l'instant où la valeur numérique de cet échantillon est fournie par le convertisseur. Ainsi, un courant de charge ou de décharge est appliqué à la capacité C pendant tous ces cycles de latence. Si la valeur N ne diffère de Nref que d'une unité, la tension Vc pourrait atteindre la valeur souhaitée au cours du premier des cycles de latence suivants. Si cela se produit, la correction continue quand même à être effectuée pendant les cycles de latence restants, ce qui éloigne de nouveau la valeur Vc de la valeur souhaitée. Comme on souhaite que l'asservissement s'effectue rapidement, on utilise des courants de charge et de décharge relativement élevés. Ainsi, cet éloignement de la tension Vc est susceptible d'être suffisant pour modifier la valeur N dans le mauvais sens. Il en résulte également une oscillation du signal N (et de la valeur Vc) avec une amplitude qui peut devenir visible à l'écran.

Le document Patent Abstracts of Japan vol. 015 no. 165 (E-1061), 25 avril 1991 & JP-A-03 035666 (Mitsubishi Electric Corp) 15 février 1991, décrit un circuit d'asservissement d'un signal analogique sur une valeur de référence, comprenant un convertisseur analogique/numérique recevant le signal analogique modifié par la charge stockée dans une capacité.

Un objet de la présente invention est de prévoir un circuit d'asservissement d'un signal sur une valeur de référence, qui soit peu sensible au bruit.

Un autre objet de la présente invention est de prévoir un tel circuit qui n'entre pas en oscillation à cause du temps de latence d'un convertisseur analogique/numérique.

Ces objets sont atteints grâce à un circuit d'asservissement du type susmentionné comprenant un registre à décalage pour stocker des sorties consécutives du comparateur numérique ; un point mémoire représentant un drapeau de condition de stabilité qui, lorsqu'il est activé, inhibe la charge et la décharge de la capacité et un circuit d'analyse du contenu du registre à décalage, pour activer le drapeau lorsque ledit contenu satisfait à une condition de stabilité prédéterminée, et pour désactiver le drapeau lorsque ledit contenu satisfait à une condition de divergence prédéterminée.

Selon un mode de réalisation de la présente invention, le circuit comprend un détecteur à fenêtre, actif lorsque la sortie du convertisseur est au voisinage de la valeur de référence, pour réduire la quantité de charge ou décharge de la capacité.

Selon un mode de réalisation de la présente invention, la quantité réduite de charge ou décharge est telle que la sortie du convertisseur varie d'au plus une unité d'une valeur à la suivante.

Selon un mode de réalisation de la présente invention, le circuit comprend un détecteur de dérive pour, lorsque le contenu du registre à décalage satisfait à une condition de dérive prédéterminée et pendant que ledit drapeau est actif, appliquer une charge ou décharge de quantité réduite.

Selon un mode de réalisation de la présente invention, la fenêtre du détecteur à fenêtre est délimitée par la valeur de référence augmentée de un et par la valeur de référence diminuée de un.

Selon un mode de réalisation de la présente invention, la condition de stabilité correspond à deux résultats d'égalité stockés dans le registre à décalage, et la condition de divergence correspond à quatre résultats d'inégalité stockés dans le registre à décalage.

Selon un mode de réalisation de la présente invention, la condition de dérive correspond à trois résultats d'inégalité, ou aux résultats inégal, égal et inégal stockés dans le registre à décalage.

Ces objets, caractéristiques et avantages ainsi que d'autres de la présente invention seront exposés plus en détail dans la description suivante de modes de réalisation particuliers, faite à titre non-limitatif à l'aide des figures jointes parmi lesquelles :
la figure 1, précédemment décrite, représente un circuit classique d'asservissement d'un signal de chrominance ou luminance sur le niveau du noir dans un téléviseur ;
la figure 2 représente une architecture de circuit d'asservissement selon la présente invention ;
la figure 3 représente un organigramme illustrant le fonctionnement du circuit de la figure 2 selon un premier mode de réalisation ; et
la figure 4 représente partiellement un organigramme illustrant le fonctionnement du circuit de la figure 2 selon un autre mode de réalisation.

La figure 2 représente des mêmes éléments qu'à la figure 1, désignés par des mêmes références. Le comparateur 14 de la figure 1 est remplacé par un comparateur 14' fournissant, par exemple, un signal A≥B actif si la valeur N est supérieure ou égale à Nref et un signal A=B actif si la valeur N est égale à Nref. Selon une variante, le comparateur 14' fournit en outre un signal A=B+1 actif si la valeur N est égale à Nref+1, et un signal A=B-1 actif si la valeur N est égale à Nref-1. Ces quatre signaux sont fournis, selon l'invention, à un circuit de commande 16 qui analyse ces signaux et commande les sources de courant Ic et Id (par les signaux UP et DN) de la manière décrite ci-après.

En résumé, selon un premier mode de réalisation, le circuit de la figure 2 fonctionne initialement comme celui de la figure 1 tant que le circuit de commande 16 détecte que les valeurs N et Nref sont différentes. Dès que le signal N se stabilise à Nref, le circuit de commande 16 entre dans un mode verrouillé où les sources Ic et Id ne sont plus activées. Dans ce cas, même si le signal Vc ou N varie aléatoirement à cause de bruit, le circuit n'effectue aucune correction qui pourrait faire osciller les signaux Vc et N.

Bien entendu, on doit effectuer une correction si le signal Vc se met à diverger, ce qui pourrait traduire une décharge de la capacité C par une résistance ou une influence parasite. Cette divergence pourrait également être causée par une variation normale de la tension non asservie V. En fait, le circuit de commande 16 analyse les valeurs successives des sorties A≥B et A=B du comparateur 14' pour détecter une condition de divergence. Si une telle condition de divergence est détectée, le circuit de commande 16 bascule en mode déverrouillé et les erreurs sont corrigées de nouveau comme dans le circuit de la figure 1.

Selon un deuxième mode de réalisation, les sorties A=B+1 et A=B-1 du comparateur 14' sont utilisées par le circuit de commande 16 pour effectuer une correction fine lorsque la valeur N est au voisinage de Nref (entre Nref-1 et Nref+1). Ainsi, le circuit a un mode de convergence rapide lorsque le signal N est distant de Nref, et un mode de convergence fin lorsque le signal N diffère de Nref d'une unité. La correction fine est choisie suffisamment faible pour que le signal N ne varie pas pendant les cycles de latence du convertisseur 12, ce qui évite une entrée en oscillation du signal Vc ou N. Selon une variante, cette correction fine est en outre utilisée lorsque le circuit de commande 16, se trouvant en mode verrouillé, détecte une condition de faible dérive insuffisante pour faire basculer le mode.

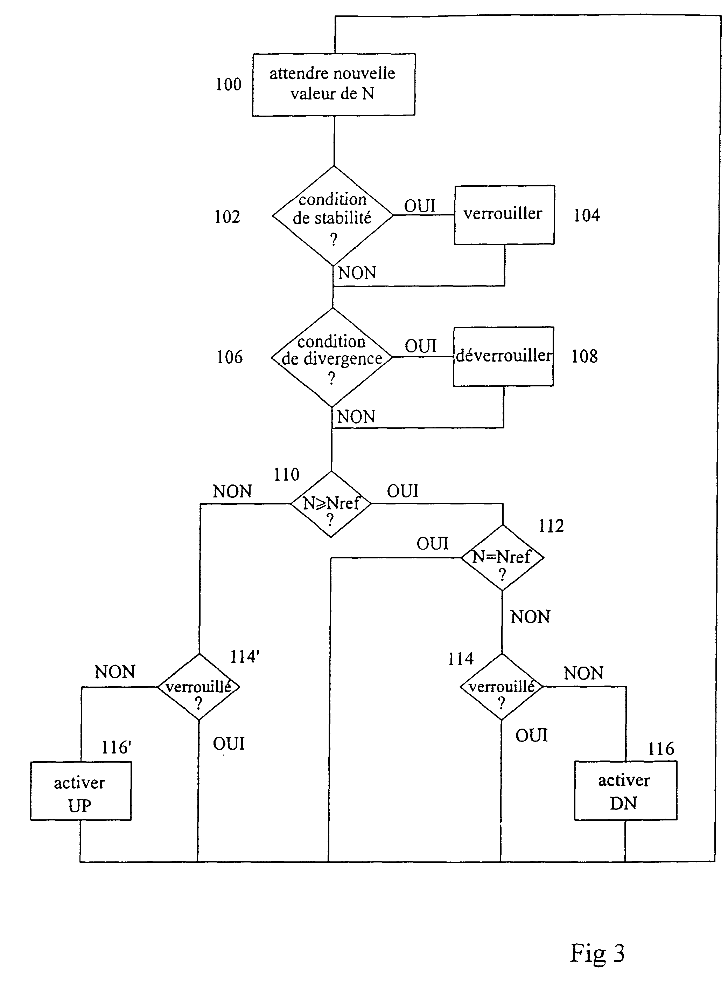

La figure 3 représente un organigramme illustrant plus en détail le fonctionnement du circuit de commande 16 selon le premier mode de réalisation. Dans les organigrammes décrits ci-après, un paragraphe décrivant un bloc d'organigramme commence par le numéro du bloc.

100. On attend une nouvelle valeur du signal N.

102. Les dernières valeurs N sont analysées pour déterminer si elles satisfont à une condition de stabilité. Cette condition de stabilité est satisfaite, par exemple, si les deux dernières valeurs N sont égales à Nref. En pratique, on n'analyse pas les valeurs N mais les valeurs de la sortie A=B du comparateur 14'. Pour cela, par exemple, le signal A=B alimente un registre à décalage de 2 bits, qui est validé à chaque nouvelle valeur N. Ainsi, si les deux bits de ce registre à décalage sont à 1, la condition de stabilité est satisfaite.

104. Si la condition de stabilité est satisfaite, le circuit passe dans un mode verrouillé indiqué, par exemple, par un drapeau correspondant à l'état d'un point mémoire (une bascule).

106. Les dernières valeurs N sont analysées pour déterminer si elles satisfont à une condition de divergence. Cette condition est satisfaite, par exemple, si les quatre dernières valeurs de N sont, soit toutes supérieures, soit toutes inférieures, à Nref. Pour cela, en pratique, on analyse les quatre derniers couples de signaux (A≥B, A=B) du comparateur 14'. La condition de divergence est satisfaite si ces quatre couples sont tous égaux à (1,0) ou à (0,0). Les signaux A≥B et A=B alimentent, par exemple, des registres à décalage respectifs de 4 bits, qui sont validés à chaque nouvelle valeur N. Le registre à décalage associé au signal A=B sert également à effectuer l'analyse de la condition de stabilité au bloc 102.

108. Si la condition de divergence est satisfaite, le circuit passe en mode déverrouillé par une dévalidation du drapeau qui avait été validé au bloc 104.

110. On vérifie si la valeur N est supérieure ou égale à Nref, ce qui revient à vérifier si le signal A>B est à 1.

112. Dans l'affirmative, on vérifie si la valeur N est égale à Nref, ce qui revient à vérifier si le signal A=B est à 1. Si c'est le cas, on se trouve dans une situation de stabilité optimale et le circuit attend une nouvelle valeur N au bloc 100.

114. La valeur N est strictement supérieure à Nref. On vérifie si le circuit est en mode verrouillé. Dans l'affirmative, la valeur N est légèrement supérieure à Nref et l'écart n'est qu'un phénonème parasite qu'il ne convient pas de corriger. Le circuit attend une nouvelle valeur N au bloc 100.

116. Le circuit n'est pas en mode verrouillé. Dans ce cas, le signal N est en phase de convergence en décroissant vers Nref, ou bien a atteint Nref mais commence à diverger en croissant. Le signal DN est activé pendant un cycle d'horloge, ce qui provoque la décharge de la capacité C par la source Id d'une quantité déterminée par le courant de la source Id, la période de l'horloge CK, et la valeur de la capacité C.

Des opérations symétriques sont effectuées si la valeur N est inférieure à Nref. On vérifie dans un bloc 114', comme dans le bloc 114, si le circuit est verrouillé. Dans l'affirmative, on n'effectue aucune correction et on attend une nouvelle valeur N au bloc 100. Dans la négative, on active dans un bloc 116' le signal UP pendant un cycle d'horloge pour charger la capacité C d'une quantité prédéterminée.

Les blocs 102 à 108, qui servent à mettre le circuit en mode verrouillé ou en mode déverrouillé, ont été intégrés dans l'organigramme de la figure 3. Toutefois, les opérations correspondantes peuvent être effectuées séparément, en parallèle avec le reste des opérations de l'organigramme.

Grâce au mode de fonctionnement qui vient d'être décrit, le circuit d'asservissement selon l'invention ne corrige pas des parasites aléatoires du signal Vc ou N, une fois que le signal N a atteint Nref. Le signal Vc ou N n'est de nouveau corrigé que s'il présente des caractéristiques de divergence (plusieurs valeurs successives supérieures ou inférieures à la valeur souhaitée).

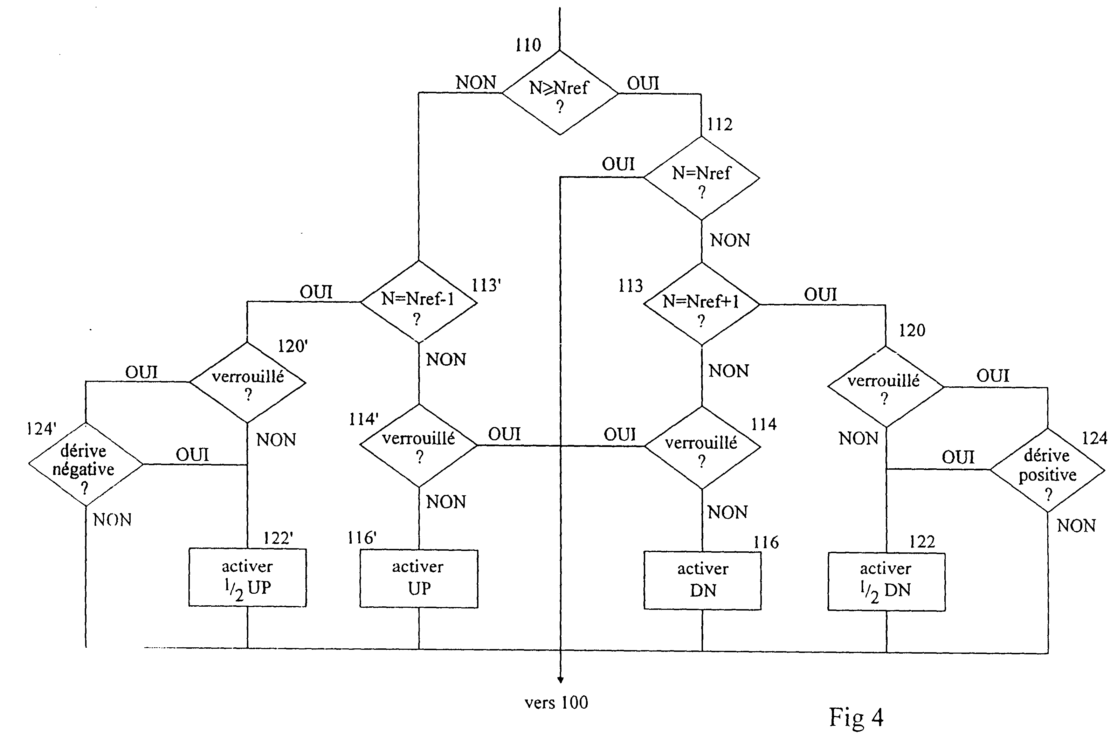

La figure 4 représente partiellement un organigramme, à partir du bloc 110 de l'organigramme de la figure 3, illustrant un fonctionnement optimisé du circuit d'asservissement selon l'invention. Cet organigramme comporte tous les blocs de la figure 3 qui ne sont pas décrits de nouveau.

113. Ce bloc est inséré entre les blocs 112 et 114. La valeur N est strictement supérieure à Nref et on vérifie si elle est égale à Nref+1. Dans la négative, les opérations continuent, comme précédemment décrit, au bloc 114 pour effectuer, si nécessaire une correction normale.

120. La valeur N est égale à Nref+1. On vérifie si le circuit est en mode verrouillé.

122. Le circuit n'est pas en mode verrouillé. A ce stade, cela signifie, soit que le signal N est en train de converger en décroissant vers Nref et se trouve au voisinage de Nref, soit que le signal N commence à diverger en croissant. On effectue alors une correction fine. La capacité C est déchargée d'une quantité réduite par rapport à celle du bloc 116. Pour effectuer cette décharge réduite, par exemple, le signal DN n'est activé que pendant une alternance de l'horloge CK, c'est-à-dire pendant une demi-période d'horloge ou même moins si le rapport cyclique de l'horloge est choisi inférieur à 0,5. La valeur optimale de cette décharge réduite est telle que la tension Vc n'atteigne pas une valeur correspondant à Nref-1 pendant les cycles de latence du convertisseur. On supprime ainsi les oscillations dues à des corrections trop importantes effectuées au voisinage de Nref. Une convergence rapide est assurée par ailleurs par les blocs 114 et 116 lorsque le signal N se trouve loin de Nref.

124. Le circuit est en mode verrouillé et la valeur N est égale à Nref+1. On vérifie si les dernières valeurs N satisfont à une condition de dérive positive qui est insuffisante pour déclencher le déverrouillage du circuit. Cette condition de dérive correspond, par exemple, à trois valeurs consécutives égales à Nref+1, celle du milieu étant éventuellement égale à Nref. Dans l'affirmative, on décide d'effectuer une correction, mais on effectue une correction fine au bloc 122. Dans la négative, aucune correction n'est effectuée et on attend une nouvelle valeur N au bloc 100.

Les opérations qui viennent d'être décrites correspondent à la correction de valeurs N supérieures à Nref. Les valeurs N inférieures à Nref sont corrigées de manière symétrique. Ainsi, dans un bloc 113', on vérifie si la valeur N est égale à Nref-1 (ce qui est indiqué par le signal A=B-1 du comparateur 14'). Dans la négative, les opérations continuent au bloc 114' de la manière décrite dans l'organigramme de la figure 3. Dans l'affirmative, on vérifie dans un bloc 120' si le circuit est en mode verrouillé. Si le circuit est en mode verrouillé, on effectue une correction fine au bloc 122', en augmentant la charge de la capacité C d'une quantité plus faible qu'au bloc 116'. Si le circuit est en mode verrouillé, on vérifie dans un bloc 124' si les dernières valeurs du signal N satisfont à une condition de dérive négative. Si c'est le cas, on effectue une correction fine au bloc 122', sinon aucune correction n'est faite.

La présente invention a été décrite essentiellement à l'aide d'organigrammes que l'homme du métier pourra facilement retranscrire, par exemple, en langage VHDL pour générer des circuits logiques effectuant les opérations souhaitées. En outre, des blocs des organigrammes peuvent être changés de place sans que cela modifie les fonctions décrites. Par exemple, le bloc 112 peut être disposé avant le bloc 110. Alors, dans le bloc 110, on vérifie si la valeur N est strictement supérieure à Nref.

## Revendications

1. Circuit d'asservissement d'un signal analogique (Vc) sur une valeur de référence, comprenant :
- un convertisseur analogique/numérique (12) recevant le signal analogique modifié par la charge stockée dans une capacité (C) ;
- un comparateur numérique (14') recevant la sortie du convertisseur et une valeur numérique de référence (Nref) ;
- des sources de charge (Ic) et de décharge (Id) de la capacité, commandées par le comparateur ;
**caractérisé en ce qu**'il comprend :
- un registre à décalage pour stocker des sorties consécutives du comparateur numérique ;
- un point mémoire représentant un drapeau (104) de condition de stabilité qui, lorsqu'il est activé, inhibe la charge et la décharge de la capacité ; et
- un circuit (14', 16) d'analyse du contenu du registre à décalage, pour activer le drapeau lorsque ledit contenu satisfait à une condition de stabilité prédéterminée, et pour désactiver le drapeau lorsque ledit contenu satisfait à une condition de divergence prédéterminée.

2. Circuit d'asservissement selon la revendication 1, **caractérisé en ce qu**'il comprend un détecteur à fenêtre (14'), actif lorsque la sortie (N) du convertisseur est au voisinage de la valeur de référence (Nref), pour réduire la quantité de charge ou décharge de la capacité (C).

3. Circuit d'asservissement selon la revendication 2, **caractérisé en ce que** la quantité réduite de charge ou décharge est telle que la sortie du convertisseur varie d'au plus une unité d'une valeur à la suivante.

4. Circuit d'asservissement selon la revendication 2, **caractérisé en ce qu**'il comprend un détecteur de dérive (124, 124') pour, lorsque le contenu du registre à décalage satisfait à une condition de dérive prédéterminée et pendant que ledit drapeau est actif, appliquer une charge ou décharge de quantité réduite.

5. Circuit d'asservissement selon la revendication 2, **caractérisé en ce que** la fenêtre du détecteur à fenêtre (14') est délimitée par la valeur de référence augmentée de un et par la valeur de référence diminuée de un.

6. Circuit d'asservissement selon la revendication 1, **caractérisé en ce que** la condition de stabilité correspond à deux résultats d'égalité stockés dans le registre à décalage, et en ce que la condition de divergence correspond à quatre résultats d'inégalité stockés dans le registre à décalage.

7. Circuit d'asservissement selon la revendication 4, **caractérisé en ce que** la condition de dérive correspond à trois résultats d'inégalité, ou aux résultats inégal, égal et inégal stockés dans le registre à décalage.

## Patentansprüche

1. Eine Schaltung zum Verriegeln oder Festlegen eines analogen Signals (Vc) auf einem Referenzwert, die folgendes aufweist:
- einen analog-zu-digital-Umwandler (12), der das von der in einem Kondensator (C) gespeicherten Ladung modifizierte analoge Signal empfängt;
- einen Digitalkomparator (14'), der den Ausgabewert des Umwandlers und einen digitalen Referenzwert (Nref) empfängt;
- Kondensator-Lade-(lc) und Entlade-(ld)-Quellen, die von dem Komparator gesteuert werden;
**dadurch gekennzeichnet**, daß sie folgendes aufweist:
- ein Schieberegister zum Speicher aufeinanderfolgender Ausgabewerte des Digitalkomparators;
- einen Speicherpunkt, der ein Stabilitätszustandskennzeichen (Flag) (104) darstellt, das bei Aktivierung das Laden und das Entladen des Kondensators verhindert; und
- eine Schaltung (14', 16) zum Analysieren des Inhalts des Umwandlers, zur Aktivierung des Kennzeichens (Flag), wenn der Inhalt eine vorbestimmte Stabilitätsbedingung erfüllt, und zum Deaktivieren des Kennzeichens, wenn der Inhalt eine vorbestimmte Divergenzbedingung erfüllt.

2. Eine Verriegelungsschaltung gemäß Anspruch 1, **dadurch gekennzeichnet**, daß sie einen Fensterdetektor (14') umfaßt, der aktiv ist, wenn der Ausgabewert (N) des Umwandlers in der Nähe des Referenzwertes (Nref) ist, zum Reduzieren der Größe der Ladung oder Entladung des Kondensators (C ).

3. Eine Verriegelungsschaltung gemäß Anspruch 2, **dadurch gekennzeichnet**, daß die reduzierte Größe der Ladung oder Entladung derart ist, daß der Ausgabewert des Umwandlers um höchstens eine Einheit von einem Wert zum folgenden variiert.

4. Eine Verriegelungsschaltung gemäß Anspruch 2, **dadurch gekennzeichnet**, daß sie einen Driffdetektor (124, 124') umfaßt, um, wenn der Inhalt des Schieberegisters eine vorbestimmte Driftbedingung erfüllt und das Kennzeichen aktiv ist, eine reduzierte Ladungs- oder Entladungsgröße anzulegen.

5. Eine Verriegelungsschaltung gemäß Anspruch 2, **dadurch gekennzeichnet**, daß das Fenster des Fensterdetektors (14') von dem um eins erhöhten Referenzwert und dem um eines verringerten Referenzwert begrenzt wird.

6. Eine Verriegelungsschaltung gemäß Anspruch 1, **dadurch gekennzeichnet**, daß die Stabilitätsbedingung (der Stabilitätszustand) zwei aufeinanderfolgenden Gleichheitsergebnissen entspricht, die in dem Schieberegister gespeichert sind, und dadurch, daß die Divergenzbedingung vier aufeinanderfolgenden Ungleichheitsergebnissen entspricht, die in dem Schieberegister gespeichert sind.

7. Eine Verriegelungsschaltung gemäß Anspruch 4, **dadurch gekennzeichnet**, daß die Driftbedingung drei Ungleichheitsergebnissen entspricht, oder ungleichen, gleichen, ungleichen Ergebnissen, die in dem Schieberegister gespeichert sind.

## Claims

1. A circuit for locking an analog signal (Vc) on a reference value, including:
- an analog-to-digital converter (12) receiving the analog signal modified by the charge stored in a capacitor (C);
- a digital comparator (14') receiving the output of the converter and a reference digital value (Nref);
- capacitor charging (Ic) and discharging (Id) sources, controlled by the comparator;
**characterized in that** it comprises:
- a shift register for storing consecutive outputs of the digital comparator;
- a memory point representing a stability condition flag (104) which, when activated, inhibits the charging and the discharging of the capacitor; and
- a circuit (14', 16) for analyzing the content of the converter, for activating the flag when said content meets a predetermined stability condition, and for deactivating the flag when said content meets a predetermined divergence condition.

2. A locking circuit according to claim 1, **characterized in that** it includes a window detector (14'), active when the output (N) of the converter is in the vicinity of the reference value (Nref), for reducing the amount of charging or discharging of the capacitor (C).

3. A locking circuit according to claim 2, **characterized in that** the reduced amount of charging or discharging is such that the output of the converter varies by one unit at most from a value to the following.

4. A locking circuit according to claim 2, **characterized in that** it includes a drift detector (124, 124') for, when the content of the shift register meets a predetermined drift condition and said flag is active, applying a reduced amount of charging or discharging.

5. A locking circuit according to claim 2, **characterized in that** the window of the window detector (14') is delimited by the reference value increased by one and by the reference value decreased by one.

6. A locking circuit according to claim 1, **characterized in that** the stability condition corresponds to two consecutive equality results stored in the shift register and in that the divergence condition corresponds to four consecutive inequality results stored in the shift register.

7. A locking circuit according to claim 4, **characterized in that** the drift condition corresponds to three inequality results, or to inequal, equal, inequal results stored in the shift register.
